# EUROPEAN PATENT SPECIFICATION

(11) **EP 0 484 289 B1**
(45) Date of publication and mention of the grant of the patent: **08.06.1994**
(21) Application number: 91830450.2
(22) Date of filing: 22.10.1991
(51) Int. Cl.: H05K 5/00, H01R 13/52

(54) **A connector for an electronic control unit**
Ein Verbinder für eine electronische Steuereinheit
Un connecteur pour unité de commande électronique

(30) Priority: 30.10.1990 IT 5334590 U
(43) Date of publication of application: 06.05.1992
(73) Proprietor: MARELLI AUTRONICA S.p.A., 20145 Milano (IT)
(72) Inventor: Maggioni, Carlo, I-10021 Cambiano (Torino) (IT)
(74) Representative: Quinterno, Giuseppe

(56) References cited:
- EP-A- 0 378 065
- DE-U- 8 430 486
- GB-A- 615 347
- US-A- 4 851 725

## Description

The present invention relates to a connector for a control unit for controlling a function of an internal combustion engine, the unit being housed in a casing formed by two half-shells whose edges have respective notches which, in the assembled configuration of the two half-shells, define an opening between the interior of the casing the exterior. The connector is characterised in that it has a body of elastomeric material having a perimetral groove which is adapted to be fitted in the opening defined by the notches in the half-shells and a plurality of through-holes substantially perpendicular to the general plane of the groove and each having at least one internal portion of enlarged cross-section defined by facing shoulders, the holes being adapted to house respective electrically conductive pins whose shapes correspond to those of the holes and the ends of which project from the body of elastomeric material.

Advantages and characteristics of the present invention will become clear from the detailed description which follows with reference to the appended drawings, provided by way of non-limiting example, in which:
Figure 1 is an exploded view of a casing in which the connector according to the invention is positioned, and
Figure 2 is a sectional view of the connector taken on the line II-II of Figure 1.

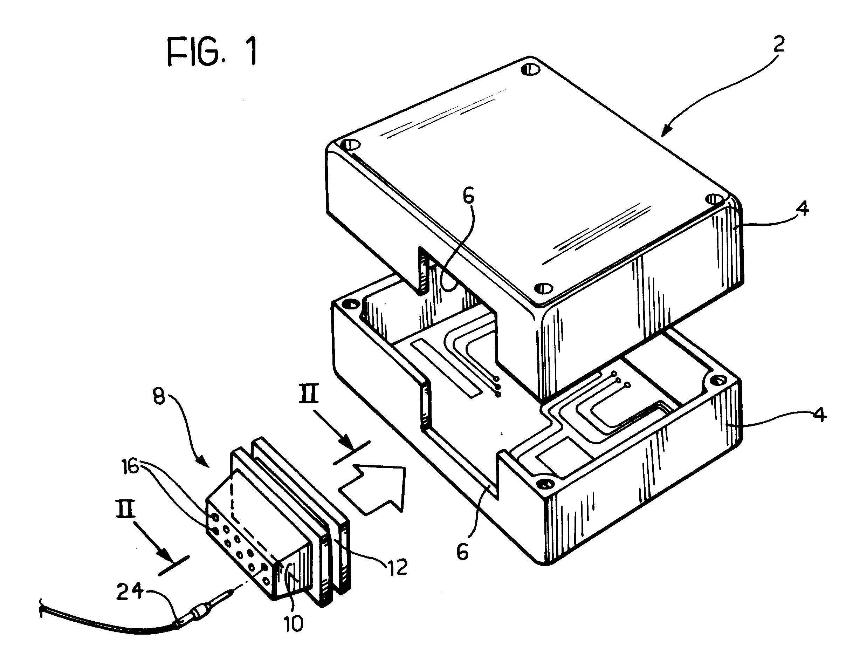

Figure 1 shows a casing 2 for a control unit, not illustrated, for controlling a function of an internal combustion engine, such as, for example, the electronic injection. The casing 2 is formed by two half-shells 4 whose edges have respective notches 6 which, in the assembled configuration of the two half-shells 4, define an opening between the interior of the casing 2 and the exterior. An electrical connector 8 positioned in the opening is adapted to connect the electrical circuits of the control unit to external electrical circuits.

The connector 8 has a body 10 of elastomeric material with a perimetral groove 12 which is adapted to be fitted with interference in the opening defined by the two half-shells 4. A seal against the infiltration of any water is thus ensured. The connector can be fitted in the casing by taking advantage of the resilient deformation characteristics of its body 10.

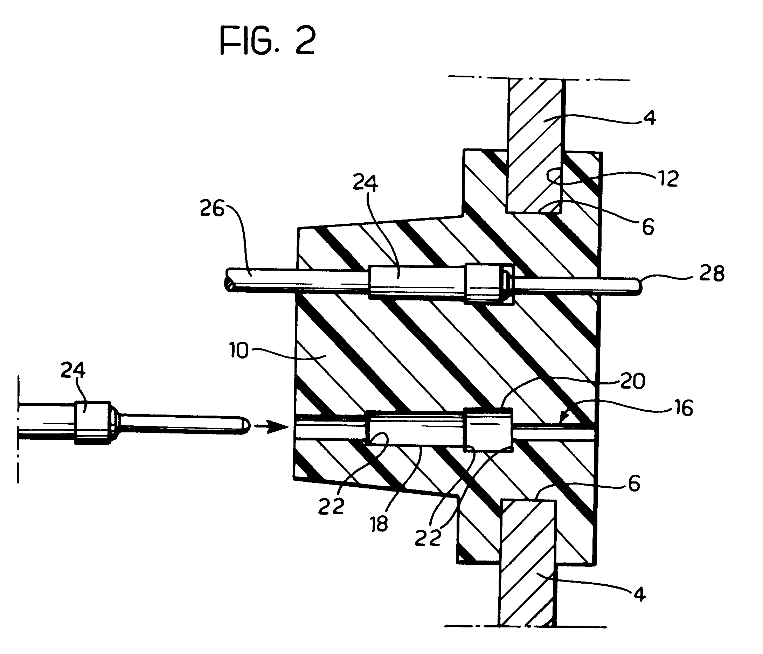

The body 10 has a plurality of through-holes 16 substantially perpendicular to the general plane of the groove 12 (Figure 2). Each hole 16 has a first internal portion 18 of enlarged cross-section and a second internal portion 20 of further enlarged cross-section adjacent the first portion 18. The limits of each portion 18, 20 of each hole 16 are defined by radial shoulders 22.

An electrically-conductive pin 24 whose shape corresponds to that of the holes 16 is positioned in each hole 16 with its ends 26, 28 projecting from the body 10 of the connector 8. The pins 24 can be inserted in the holes 16 by virtue of the resilience of the elastomeric body 10 and are retained therein by the abutment between the shoulders 22 and the ends of the enlarged cross-section portions 18, 20 of the pins 24. Radial interference between the facing surfaces of the enlarged portions 18, 20 of the holes 16 and the pins 24 also prevents any infiltration by this route.

The ends 26 of the pins are adapted to mate with a corresponding female connector, not shown, which is connected to the external electrical circuits and the ends 28 are intended to mate with terminals, not shown, of the electrical circuits of the control unit.

## Claims

1. A connector (8) and a casing for a control unit for controlling a function of an internal combustion engine, the unit being housed in the casing (2) formed by two half-shells (4) whose edges have respective notches (6) which, in the assembled configuration of the two half-shells (4) define an opening between the interior of the casing (2) and the exterior, the connector (8) being characterised in that it has a body (10) of elastomeric material having a perimetral groove (12) which is adapted to be fitted in the opening defined by the notches (6) in the half-shells (4) and a plurality of through-holes (16) substantially perpendicular to the general plane of the groove (12) and each having at least one internal portion (18, 20) of enlarged cross-section defined by facing shoulders (22), the holes (16) being adapted to house respective electrically conductive pins (24) whose shapes correspond to those of the holes (16), and the ends (26, 28) of which project from the body (10) of elastomeric material.

2. A connector (8) according to Claim 1, characterised in that the groove (12) in the connector (8) fits with interference in the opening defined by the half-shells (4) so as to ensure a hydraulic seal.

3. A connector (8) according to any one of the preceding claims, characterised in that each hole (16) has a first portion (18) of enlarged cross-section and a second portion (20) adjacent the first portion (18) having a further enlarged cross-section.

4. A connector (8) according to any one of the preceding claims, characterised in that there is radial interference between each pin (24) and the at least one enlarged cross-section portion (18, 20) of its hole (16).

## Patentansprüche

1. Verbinder (8) und Gehäuse für eine Steuereinheit zum Steuern einer Funktion einer Verbrennungskraftmaschine, wobei die Einheit im Gehäuse (2) eingeschlossen ist, das aus zwei Halbschalen (4) gebildet wird, deren Ränder jeweils Ausschnitte (6) haben, die in der zusammengesetzten Anordnung der beiden Halbschalen (4) zwischen dem Inneren und dem Äußeren des Gehäuses (2) eine Öffnung bestimmen,
**dadurch gekennzeichnet,**
daß der Verbinder (8) einen Körper (10) aus elastomerem Material mit einer Umfangsaussparung (12) zum Einfügen in die von den Ausschnitten (6) in den Halbschalen (4) festgelegte Öffnung und einer Vielzahl von Durchgangslöchern (16) hat, die im wesentlichen rechtwinklig zur Hauptebene der Umfangsaussparung (12) verlaufen und von denen jede wenigstens einen inneren Teil (18, 20) mit vergrößertem Querschnitt hat, der durch Anlegeschultern (22) bestimmt ist, und daß die Durchgangslöcher (16) zur Unterbringung jeweils elektrisch leitender Stifte (24) ausgebildet sind, deren Umrisse denjenigen der Durchgangslöcher (16) entsprechen und deren Enden (26, 28) aus dem Körper (10) aus elastomerem Material vorspringen.

2. Verbinder (8) nach Anspruch 1,
**dadurch gekennzeichnet**,
daß die Umfangsaussparung (12) im Verbinder (8) im Paßsitz in die von den Halbschalen (4) bestimmte Öffnung eingefügt ist, um eine hydraulische Dichtung zu bilden.

3. Verbinder (8) nach irgendeinem der vorhergehenden Ansprüche,
**dadurch gekennzeichnet**,
daß jedes Durchgangsloch (16) einen ersten Teil (18) mit vergrößertem Querschnitt und einen zweiten Teil (20) hat, der dem ersten Teil (18) benachbart ist und einen weiter vergrößerten Querschnitt hat.

4. Verbinder (8) nach irgendeinem der vorhergehenden Ansprüche,
**dadurch gekennzeichnet,**
daß ein radialer Paßsitz zwischen jedem Stift (24) und dem wenigstens einen Teil (18, 20) seines Durchgangslochs (16) vorgesehen ist, der einen vergrößerten Querschnitt hat.

## Revendications

1. Connecteur (8) et boîtier destinés à une unité de commande servant à commander une fonction d'un moteur à combustion interne, l'unité étant logée dans le boîtier (2) formé par deux demi-capots (4) dont les bords présentent respectivement des entailles (6) qui, dans la configuration assemblée des deux demi-capots (4), définissent une ouverture entre l'intérieur du boîtier (2) et l'extérieur, le connecteur (8) étant caractérisé en ce qu'il présente un corps (10) en matériau élastomère présentant une gorge périphérique (12), qui est adaptée pour être montée dans l'ouverture définie par les entailles (6) dans les demi-capots (4) et une pluralité de trous traversants (16), pratiquement perpendiculaires au plan global de la gorge (12) et présentant chacun au moins une partie interne (18, 20) à section transversale agrandie, définie par des épaulements (22) se faisant face, les trous (16) étant adaptés de façon à loger, respectivement, des broches (24) conductrices de l'électricité, dont les formes correspondent à celles des trous (16) et dont les extrémités (26, 28) font saillie du corps (10) en matériau élastomère.

2. Connecteur (8) selon la revendication 1, caractérisé en ce que la gorge (12) ménagée dans le connecteur (8) s'insère avec ajustement serré dans l'ouverture définie par les demi-capots (4), de manière à assurer un joint d'étanchéité à l'eau.

3. Connecteur (8) selon l'une quelconque des revendications précédentes, caractérisé en ce que chaque trou (16) présente une première partie (18) à section transversale agrandie et une seconde partie (20) adjacente à la première partie (18), présentant une section transversale encore plus grande.

4. Connecteur (8) selon l'une quelconque des revendications précédentes, caractérisé en ce qu'il existe une interférence radiale entre chaque broche (24) et la ou les partie (s) (18, 20) à section transversale agrandie de son trou (16).
